# EUROPEAN PATENT SPECIFICATION

(11) **EP 1 683 211 B1**
(45) Date of publication and mention of the grant of the patent: **06.01.2010**
(21) Application number: 04770282.4
(22) Date of filing: 19.10.2004
(51) Int. Cl.: H01L 51/30, H01L 51/50, H01L 51/10

(54) **LIGHT-EMITTING DEVICE WITH INCREASED QUANTUM EFFICIENCY**
LICHTAUSSENDENDES GERÄT MIT VERBESSERTER QUANTENAUSBEUTE
DISPOSITIF ELECTROLUMINESCENT A RENDEMENT QUANTIQUE ACCRU

(30) Priority: 29.10.2003 EP 03104018
(43) Date of publication of application: 26.07.2006
(73) Proprietor: Philips Intellectual Property & Standards GmbH, 20099 Hamburg (DE); Koninklijke Philips Electronics N.V., 5621 BA Eindhoven (NL)
(72) Inventor: Boerner, Herbert, Friedrich, 52066 Aachen (DE); Busselt, Wolfgang, 52066 Aachen (DE); Bertram, Dietrich, 52066 Aachen (DE)
(74) Representative: Volmer, Georg
(86) International application number: PCT/IB2004/052135
(87) International publication number: WO 2005/043581

(56) References cited:
- WO-A-02/41414
- WO-A-03/012890
- WO-A-03/083958
- HUANG JINGSONG ET AL: "Low-voltage organic electroluminescent devices using pin structures" APPLIED PHYSICS LETTERS, AMERICAN INSTITUTE OF PHYSICS. NEW YORK, US, vol. 80, no. 1, 7 January 2002 (2002-01-07), pages 139-141, XP012030202 ISSN: 0003-6951

## Description

The invention relates to a light-emitting device which comprises at least a substrate, an anode, a hole transport layer, a light-emitting layer and a cathode.

Electronically controlled display systems are known and widely used in various embodiments based on various principles.

One principle uses organic light-emitting diodes, so-called OLEDs, as light source. Organic light-emitting diodes are composed of a number of functional layers. A typical structure of an OLED is described in "Philips Journal of Research, 1998, 51, 467". A typical structure comprises a layer of ITO (indium tin oxide) as transparent electrode (anode), a conductive polymer layer, an electroluminescent layer, that is to say a layer comprising a light-emitting material, and an electrode (cathode) consisting of a metal, preferably a metal with a low work function. Such a structure is customarily applied to a substrate, usually glass. The light produced reaches the observer through the substrate.

The light-emitting material used may be for example a light-emitting polymer. An OLED comprising a light-emitting polymer in the electroluminescent layer is also referred to as a polyLED or PLED.

However, an OLED may also comprise small light-emitting molecules as light-emitting material in the electroluminescent layer. An OLED comprising small light-emitting molecules in the electroluminescent layer is also referred to as a SMOLED (Small Molecule Organic Light-Emitting Diode). In this embodiment, the light-emitting materials are embedded in a matrix consisting of a hole- or electron-conductive material.

In the electroluminescent layer, holes and electrons meet and recombine. As a result, the light-emitting material is excited either directly or via energy transfer. The excited light-emitting material returns to the basic state with emission of light.

The successful recombination of charge carriers depends inter alia on the amount of charge carriers. Balanced hole and electron current densities are a prerequisite for efficient electroluminescence. In most organic materials, the hole mobility is approximately two orders of magnitude larger than the electron mobility (10⁻³ cm²/Vs compared to 10⁻ (10⁻³ cm²/Vs compared to 10⁻⁵ cm²/Vs). Thus, in most cases, the holes are the majority charge carriers and can pass through the light-emitting layer without forming excitons since they do not meet any electron for recombination. In order to prevent these holes from flowing to the cathode, a hole blocking layer is inserted between the electroluminescent layer and the cathode. The hole blocking layer comprises a material into which the holes cannot be easily injected and/or in which the mobility thereof is low. The material of the hole blocking layer can therefore be oxidized only with relative difficulty. On account of the hole blocking layer, the holes gather in the electroluminescent layer.

However, the free charge carriers, holes and electrons, may react with molecules that are already excited (excitons), wherein the excited molecules return to the basic state without any light emission. The excited molecules are thus quenched and the quantum efficiency of the OLED is reduced. These reactions represent a great source of loss in OLEDs, since the excess holes gather in the region in which the excited molecules are generated, namely in the electroluminescent layer.

Document WO 02/41414 A1 discloses an OLED device comprising a single blocking layer between light emitting layer and hole transporting layer. The HOMO energy levels of hole transporting layer, hole blocking layer and light emitting layer are adjusted with a certain relation to each other in order to increase the quantum efficiency of the OLED device. However, there is a demand of further increase of quantum efficiency. Further reference is made to WO 03/083958 A2 WO 03/012890 A2 and to J. Huang et al., Applied Physics Letters, 80, 1, 139-141.

It is therefore an object of the present invention to provide a light-emitting device with an increased quantum efficiency.

This object is achieved by a light-emitting device comprising at least a substrate, an anode, a hole transport layer, a light-emitting layer and a cathode, a first hole blocking layer arranged between the hole transport layer and the light-emitting layer, wherein a layer structure consisting of at least one further hole blocking layer and one further hole transport layer is arranged between the first hole transport layer and the anode.

By virtue of the insertion of a hole blocking layer between the hole transport layer and the light-emitting layer, the number of holes in the light-emitting layer is reduced and can be adapted to the number of electrons which reach the light-emitting layer. A large number of holes gather in the hole transport layer and cannot react with excited light-emitting molecules and the flow of holes into the light-emitting layer can be regulated more precisely.

The advantageous embodiment of a light-emitting device as claimed in claim 2 prevents the holes from reaching the cathode and being lost for the purposes of light production.

By virtue of the advantageous embodiments as claimed in claim 3 the flow of holes into the light-emitting layer can be regulated even more precisely.

By virtue of the advantageously selected materials as claimed in claims 4 and 5, efficient hole blocking layers are obtained.

By virtue of the advantageous embodiment as claimed in claim 6, the quenching of the light emission through the cathode is reduced and the injection of electrons into the light-emitting device is improved.

The invention according to claim 1 will be further described with reference to examples and illustrations shown in the drawings to which, however, the invention is not restricted. The scope of the present invention is defined by the appended claims.

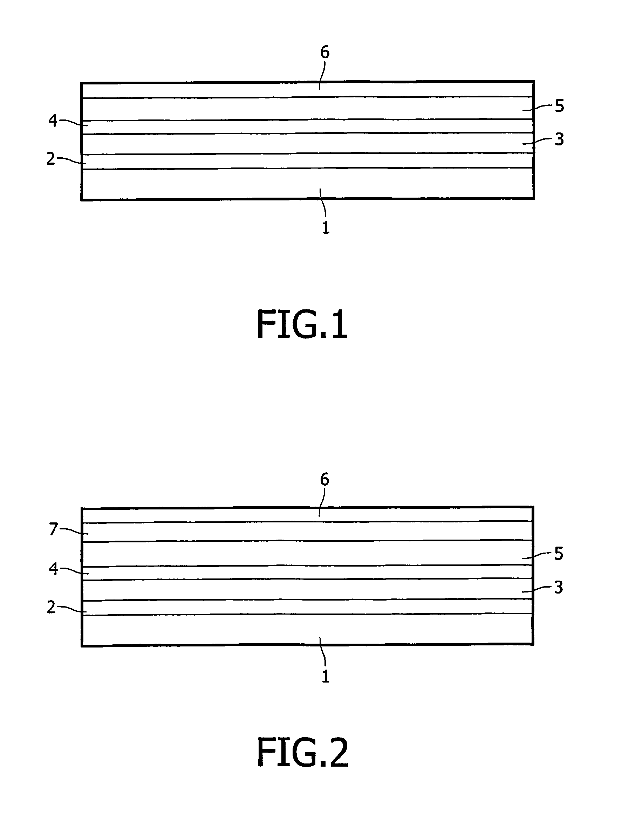

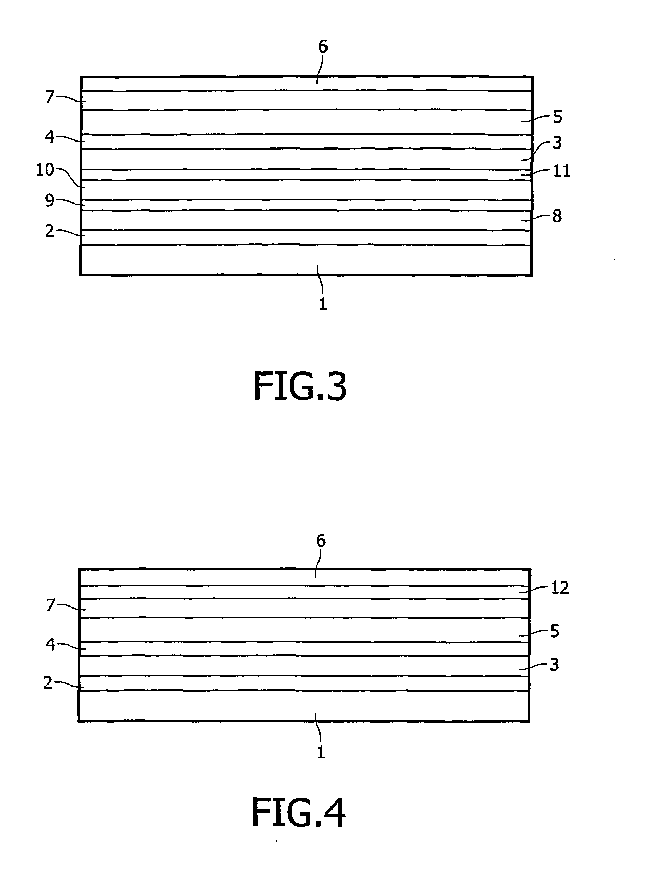

Fig. 3 shows a light-emitting device according to the invention; the devices shown in Figs. 1, 2 and 4 are shown for illustration.

All the embodiments of a light-emitting device have a substrate 1 and, applied thereto, at least an anode 2, a first hole transport layer 3, a light-emitting layer 5 and a cathode 6.

As shown in Fig. 1, a light-emitting device has a substrate 1, preferably a transparent glass plate or a transparent plastic plate. The plastic plate may comprise for example polyethylene terephthalate (PET). Adjoining the substrate 1 is a layer body which comprises at least an anode 2, a hole transport layer 3, a first hole blocking layer 4, a light-emitting layer 5 and a cathode 6.

The anode 2 is preferably transparent and may comprise for example p-doped silicon, indium-doped tin oxide (ITO) or antimony-doped tin oxide (ATO). The anode 2 preferably comprises ITO. The anode 2 is not structured, but rather is designed as a flat surface. The cathode 6 may comprise for example a metal such as aluminum, copper, silver or gold, an alloy or n-doped silicon. It may be preferable for the cathode 6 to have two or more conductive layers. It may in particular be preferable for the cathode 6 to comprise a first layer of an alkaline-earth metal, such as calcium or barium for example, or an alkali metal halide, such as LiF for example, or lithium benzoate, and a second layer of aluminum. The cathode 6 may be structured and comprise for example a large number of parallel strips of the conductive material or materials. Alternatively, the cathode 6 may not be structured and may be designed as a flat surface.

The light-emitting layer 5 may comprise a light-emitting polymer or small light-emitting molecules as light-emitting material. The light-emitting polymer used may be for example poly(*p*-phenylvinylene) (PPV) or a substituted PPV, such as dialkoxy-substituted PPV for example. If the light-emitting layer 5 comprises small light-emitting molecules, these are preferably embedded in a matrix consisting of a hole or electron transport material. The choice of matrix material depends on the requirements of the small light-emitting molecules. By way of example, the light-emitting layer may comprise tris(2-phenylpyridine)iridium(III) (Ir(ppy)₃) embedded in a matrix of 4,4',4"-tri(*N-*carbazolyl)triphenylamine (TCTA) or Ir(ppy)₃ embedded in a matrix of 2,9-dimethyl-4,7-diphenyl-1,10-phenanthroline (BCP).

Adjoining the anode 2 is a first hole transport layer 3, which facilitates the injection and transport of the holes into the device.

The first hole blocking layer 4, which is located between the hole transport layer 3 and the light-emitting layer 5, is relatively difficult to oxidize and thus the number of holes which reach the light-emitting layer 5 per unit time is reduced.

The first hole blocking layer 4 comprises a material which is more difficult to oxidize than the adjacent hole transport layer 3. Preferably, the HOMO (Highest Occupied Molecular Orbital) energy level of the material of the hole blocking layer 4 is lower than the HOMO energy level of the material of the adjoining hole transport layer 3. The greater the energy difference between the HOMO energy levels, the greater the blocking property of the first hole blocking layer 4. In this embodiment, the holes gather in the hole transport layer 3, namely in the region where it adjoins the first hole blocking layer 4.

The material of the hole transport layer 3 should have a low ionization potential with a low electron affinity. However, the HOMO energy level should be so high that injection of the holes out of the anode 2 is possible without overcoming an energy barrier. Suitable materials for the hole transport layer 3 are, for example, triarylamines, diarylamines, tristilbeneamines or a mixture of polyethylene dioxythiophene (PDOT) and polystyrene sulfonate.

For the first hole blocking layer 4 and the hole transport layer 3, the distance between HOMO and LUMO (Lowest Unoccupied Molecular Orbital) of the respective materials of the two layers must be greater than the HOMO-LUMO distance of the light-emitting material in the light-emitting layer 5, in order that the light produced there is not absorbed.

Fig. 2 shows a further aspect of a light-emitting device according to the invention. This light-emitting device has in addition a further, second hole blocking layer 7 which prevents holes from passing from the light-emitting layer 5 to the cathode 6. The material of the second hole blocking layer 7 is also relatively difficult to oxidize. Preferably, the HOMO (Highest Occupied Molecular Orbital) energy level of the material of the second hole blocking layer 7 is lower than the HOMO energy level of the light-emitting material of the adjoining light-emitting layer 5. Here, too, the greater the energy difference between the HOMO energy levels, the greater the blocking property of the second hole blocking layer 7.

Fig. 3 shows an embodiment of a light-emitting device according to the invention. This light-emitting device has, between the anode 2 and the first hole transport layer 3, a layer structure comprising a large number of layers. The layer structure has at least one further hole blocking layer and one further hole transport layer. In the embodiment shown in Fig. 3, the layer structure between the first hole transport layer 3 and the anode 2 has two further hole transport layers 8, 10 and two further hole blocking layers 9, 11. The hole transport layers 8, 10 are arranged such that they alternate with the hole blocking layers 9, 11 of the layer structure.

In all the embodiments, a hole transport layer 3, 8, 10 always adjoins the anode 2.

An advantageous feature of this embodiment is that the concentration of holes which reach the light-emitting layer 5 can be adapted precisely to the concentration of electrons which pass into the light-emitting layer 5.

The individual hole blocking layers 4, 7, 9, 11 may comprise the same material or different materials. The same applies in respect of the hole transport layers 3, 8, 10.

Suitable materials for the hole blocking layers 4, 7, 9, 11 are, for example, 2,9-dimethyl-4,7-diphenyl-1,10-phenanthroline (Bathocuproin, BCP), 3-(4-biphenylyl)-4-phenyl-5-tert-butylphenyl-1,2,4-triazole (TAZ), 2-(4-biphenyl)-5-(*p*-tert-butylphenyl)-1,3,4-oxadiazole (tBu-PBD), 2-(4-biphenylyl)-5-(4-tert-butylphenyl)-1,2,4-oxadiazole (PBD), 1,3,5-tris-(1-phenyl-1H-benzimidazol-2-yl)benzene (TBPI) or oligophenyls with perfluorinated side chains.

The layer thicknesses of the hole blocking layers 4, 7, 9, 11 depends on the type of material used in the layer and the hole blocking properties thereof. When the same materials are used in all the hole blocking layers 4, 7, 9, 11, the respective layer thicknesses of the first, third and fourth hole blocking layers 4, 9, 11 are usually smaller than the layer thickness of the second hole blocking layer 7. Preferably, the layer thicknesses of the first, third and fourth hole blocking layers 4, 9, 11 are in each case between 0.1 and 10 nm. It is particularly preferable that the layer thicknesses are in each case between 0.1 and 5 nm. More particularly preferably, the layer thicknesses are in each case between 0.1 and 2 nm. Most particularly preferably, the layer thicknesses are between 0.1 and 0.5 nm.

In all the embodiments, an electron transport layer 12 may be located between cathode 6 and light-emitting layer 4 or between cathode 6 and second hole blocking layer 7. The material of such an electron transport layer is characterized by a high electron affinity. Suitable materials are, for example, tris-(8-hydroxyquinolato)aluminum (Alq₃) or electron-poor heterocycles such as 1,3,4-oxadiazoles or 1,2,4-triazoles. Fig. 4 shows a light-emitting device which has an electron transport layer 12 between the cathode 6 and the second hole blocking layer 7.

### ILLUSTRATIVE EXAMPLE

A 150 nm-thick layer of ITO, acting as anode 2, was applied to a transparent substrate 1 made of glass. A 30 nm-thick layer of α-NPD was applied as first hole transport layer 3 to the anode 2 by means of spin-coating. A first hole blocking layer 4 of BCP, having a layer thickness of 1 nm, was applied to the hole transport layer 3. A light-emitting layer 5 of Ir(ppy)₃ embedded in TCTA was applied to the first hole blocking layer 4. The layer thickness of the light-emitting layer 5 was 30 nm. A 10 nm-thick second hole blocking layer 7 of BCP was applied to the light-emitting layer 5. A 40 nm-thick layer of Alq₃ was applied as electron transport layer 12 to the second hole blocking layer 7. A 151.5 nm-thick cathode 6 consisting of a 1.5 nm-thick first layer of lithium benzoate and a 150 nm-thick second layer of aluminum was applied to the electron transport layer 12.

A light-emitting device according to the invention had a quantum efficiency which was increased by about 15% compared to a light-emitting device without the first hole blocking layer 4.

## Claims

1. A light-emitting device, comprising at least a substrate (1), an anode (2), a first hole transport layer (3), a light-emitting layer (5) and a cathode (6), wherein a first hole blocking layer (4) is arranged between the first hole transport layer (3) and the light-emitting layer (5),
**characterized in that** a layer structure consisting of at least one further hole blocking layer (9, 11) and one further hole transport layer (8, 10) is arranged between the first hole transport layer (3) and the anode (2).

2. A light-emitting device as claimed in claim 1, **characterized in that** a second hole blocking layer (7) is arranged between the cathode (6) and the light-emitting layer (5).

3. A light-emitting device as claimed in claim 1, **characterized in that** the further hole blocking layers (9, 11) and hole transport layers (8, 10) are arranged in an alternating manner.

4. A light-emitting device as claimed in any of claims 1 to 3, **characterized in that** the oxidation potential of the material of a hole blocking layer (4,9,11) is higher than the oxidation potential of an adjoining hole transport layer (3, 8, 10).

5. A light-emitting device as claimed in any of claims 1 to 3, **characterized in that** the material of a hole blocking layer (4, 7, 9, 11) is selected from the group consisting of 2,9-dimethyl-4,7-diphenyl-1,10-phenanthroline (Bathocuproin, BCP), 3-(4-biphenylyl)-4-phenyl-5-tert-butylphenyl-1,2,4-triazole (TAZ), 2-(4-biphenyl)-5-(*p*-tert-butylphenyl)-1,3,4-oxadiazole (tBu-PBD), 2-(4-biphenylyl)-5-(4-tert-butylphenyl)-1,2,4-oxadiazole (PBD), 1,3,5-tris-(1-phenyl-1H-benzimidazol-2-yl)benzene (TBPI) and oligophenyls with perfluorinated side chains.

6. A light-emitting device as claimed in any of claims 1 to 5, **characterized in that** an electron transport layer (12) is arranged between cathode (6) and light-emitting layer (5).

## Patentansprüche

1. Licht emittierende Einrichtung, mit zumindest einem Substrat (1), einer Anode (2), einer ersten Lochtransportschicht (3), einer Licht emittierenden Schicht (5) sowie einer Katode (6), wobei eine erste Lochblockierschicht (4) zwischen der ersten Lochtransportschicht (3) und der Licht emittierenden Schicht (5) angeordnet ist,
**dadurch gekennzeichnet, dass** eine aus mindestens einer weiteren Lochblockierschicht (9, 11) und einer weiteren Lochtransportschicht (8, 10) bestehende Schichtstruktur zwischen der ersten Lochtransportschicht (3) und der Anode (2) angeordnet ist.

2. Licht emittierende Einrichtung nach Anspruch 1, **dadurch gekennzeichnet, dass** eine zweite Lochblockierschicht (7) zwischen der Katode (6) und der Licht emittierenden Schicht (5) angeordnet ist.

3. Licht emittierende Einrichtung nach Anspruch 1, **dadurch gekennzeichnet, dass** die weiteren Lochblockierschichten (9, 11) und Lochtransportschichten (8, 10) abwechselnd angeordnet sind.

4. Licht emittierende Einrichtung nach einem der Ansprüche 1 bis 3, **dadurch gekennzeichnet, dass** das Oxidationspotential des Materials einer Lochblockierschicht (4, 9, 11) höher als das Oxidationspotential einer benachbarten Lochtransportschicht (3, 8, 10) ist.

5. Licht emittierende Einrichtung nach einem der Ansprüche 1 bis 3, **dadurch gekennzeichnet, dass** das Material einer Lochblockierschicht (4, 7, 9, 11) aus der Gruppe, bestehend aus 2,9-Dimethyl-4,7-diphenyl-1,10-phenanthrolin (Bathocuproin, BCP), 3-(4-Biphenylyl)-4-phenyl-5-tert-butylphenyl-1,2,4-triazol (TAZ), 2-(4-Biphenyl)-5-(*p*-tert-butylphenyl)-1,3,4-oxadiazol (tBu-PBD), 2-(4-Biphenylyl)-5-(4-tert-butylphenyl)-1,2,4-oxadiazol (PBD), 1,3,5-Tris-(1-phenyl-1H-benzimidazol-2-yl)benzol (TBPI) und Oligophenylen mit perfluorierten Seitenketten, ausgewählt wird.

6. Licht emittierende Einrichtung nach einem der Ansprüche 1 bis 5, **dadurch gekennzeichnet, dass** eine Elektronentransportschicht (12) zwischen Katode (6) Licht emittierender Schicht (5) angeordnet ist.

## Revendications

1. Dispositif émetteur de lumière comprenant au moins un substrat (1), une anode (2), une première couche de transport de trous (3), une couche émettrice de lumière (5) et une cathode (6), dans lequel une première couche de blocage de trous (4) est déposée entre la première couche de transport de trous (3) et la couche émettrice de lumière (5), **caractérisé en ce qu'**une structure en couches constituée d'au moins une nouvelle autre couche de blocage de trous (9, 11) et d'une nouvelle autre couche de transport de trous (8, 10) est agencée entre la première couche de transport de trous (3) et l'anode (2).

2. Dispositif émetteur de lumière selon la revendication 1, **caractérisé en ce qu'**une deuxième couche de blocage de trous (7) est déposée entre la cathode (6) et la couche émettrice de lumière (5).

3. Dispositif émetteur de lumière selon la revendication 1, **caractérisé en ce que** les nouvelles autres couches de blocage de trous (9, 11) et les couches de transport de trous (8, 10) sont déposées d'une manière alternative.

4. Dispositif émetteur de lumière selon l'une quelconque des revendications précédentes 1 à 3, **caractérisé en ce que** le potentiel d'oxydation du matériau d'une couche de blocage de trous (4, 9, 11) est supérieur au potentiel d'oxydation d'une couche contiguë de transport de trous (3, 8, 10).

5. Dispositif émetteur de lumière selon l'une quelconque des revendications précédentes 1 à 3, **caractérisé en ce que** le matériau d'une couche de blocage de trous (4, 7, 9, 11) est sélectionné parmi le groupe constitué de 2,9-diméthyle-4,7-diphényle-1,10-phénanthroline (Bathocuproine, BCP), de 3-(4-biphénylyle)-4-phényle-5-tert-butylephényle-1,2,4 triazole (TAZ), de 2-(4-biphényle)-5-(*p*-tert-butylephényle)-1,3,4-oxadiazole (tBu-PBD), de 2-(4-biphénylyle)-5-(4-tert-butylephényle)-1,2,4-oxadiazole (PBD), de 1,3,5-tris-(1-phényle-1H-benzimidazole-2-yl)benzène (TBPI) et d'oligophényles avec des chaînes latérales perfluorées.

6. Dispositif émetteur de lumière selon l'une quelconque des revendications précédentes 1 à 5, **caractérisé en ce qu'**une couche de transport d'électrons (12) est déposée entre la cathode (6) et la couche émettrice de lumière (5).
